# EUROPÄISCHE PATENTANMELDUNG

(11) **EP 1 926 156 A2**
(43) Veröffentlichungstag der Anmeldung: **28.05.2008**
(21) Anmeldenummer: 07116906.4
(22) Anmeldetag: 21.09.2007
(51) Int. Cl.: H01L 41/083

(54) **Piezoaktor mit übereinandergestapelten Piezoelementen**

(30) Priorität: 21.11.2006 DE 102006054701
(71) Anmelder: ROBERT BOSCH GMBH, 70442 Stuttgart (DE)
(72) Erfinder: Benes, Jan, 96047, Bamberg (DE)

(57) **Zusammenfassung**

Es wird ein Piezoaktor mit einem Mehrschichtaufbau von Piezoelementen (2) vorgeschlagen, die jeweils aus zwischen Innenelektroden (3,4) eingefassten Piezolagen bestehen, an die in einem aktiven Bereich über eine wechselseitige seitliche Kontaktierung der Innenelektroden (3,4) mittels Außenelektroden (6,7) eine elektrische Spannung anlegbar ist. Es ist mindestens ein passiver Bereich an den kopf- und/oder fußseitigen Enden des Mehrschichtaufbaus der Piezoelemente (2) ohne eine wechselseitige Kontaktierung angeordnet, wobei eine erhöhte Schichtdicke der Piezolagen (13') im aktiven Bereich zu den kopf- und/oder fußseitigen Enden des Mehrschichtaufbaus vorhanden ist. Um Rissbildungen zu vermeiden, setzt sich eine Erhöhung mindestens der Schichtdicke der letzten Piezolage (13') im aktiven Bereich in Form einer mindestens gleichen Schichtdicke der mindestens ersten angrenzenden Piezolage (13') im jeweiligen passiven Bereich zu den kopf- und/oder fußseitigen Enden des Mehrschichtaufbaus hin fort.

## Beschreibung

### Stand der Technik

Die Erfindung betrifft einen Piezoaktor, bestehend aus übereinandergestapelten Piezoelementen, die aus jeweils mit Innenelektroden eingefassten Piezolagen gebildet sind, nach den gattungsgemäßen Merkmalen des Hauptanspruchs.

Ein solcher Piezoaktor kann beispielsweise in einem Piezoinjektor zur zeitpunkt- und mengengenauen Dosierung von Kraftstoff in einem Verbrennungsmotor eingesetzt werden. Dieser Piezoinjektor besteht im Wesentlichen aus einem Haltekörper und dem in dem Haltekörper angeordneten Piezoaktor mit den Piezoelementen.

Es ist an sich bekannt, dass der Piezoaktor so eingesetzt werden kann, dass unter Ausnutzung des sogenannten Piezoeffekts eine Steuerung des Nadelhubes eines Ventils oder dergleichen vorgenommen werden kann. Die Piezolagen der Piezoelemente sind aus einem Material mit einer geeigneten Kristallstruktur so aufgebaut, dass bei Anlage einer äußeren elektrischen Spannung eine mechanische Reaktion der Piezoelemente erfolgt, die in Abhängigkeit von der Kristallstruktur und der Anlagebereiche der elektrischen Spannung einen Druck oder Zug in eine vorgebbare Richtung darstellt. Derartige Piezoaktoren eignen sich beispielsweise für Anwendungen, bei denen Hubbewegungen unter hohen Betätigungskräften und hohen Taktfrequenzen ablaufen.

Beispielsweise ist ein solcher Piezoaktor aus der DE 199 46 835 A1 bekannt, der zum Beispiel als Bestandteil eines Piezoinjektors in sogenannten Common Rail Einspritzsystemen (CR-Injektor) eingesetzt werden kann. Bei diesem Piezoaktor ist ebenfalls ein Stapel mehrerer elektrisch und mechanisch miteinander gekoppelter Piezoelemente vorhanden, die über einen Aktorfuß und einen Aktorkopf unter Vorspannung zwischen zwei Anschlägen gehalten sind. Jede piezokeramische Piezolage der Piezoelemente ist auch hier in der Regel zwischen zwei Innenelektroden eingefasst, über die von außen eine elektrische Spannung angelegt werden kann. Aufgrund dieser elektrischen Spannung führen die Piezoelemente dann jeweils kleine Hubbewegungen in Richtung des Potenzialgefälles aus, die sich zum Gesamthub des Piezoaktors addieren. Dieser Gesamthub ist über die Höhe der angelegten Spannung veränderbar und kann auf ein mechanisches Stellglied übertragen werden.

Bei dem zuvor erwähnten Piezoaktor wird zur Heranführung der unterschiedlichen Potenziale eine wechselseitige seitliche Kontaktierung der Innenelektroden über äußere Elektroden vorgenommen, bei der leitende Flächen auf jeweils einer Seitenfläche des Piezoaktors angebracht sind, die mit den jeweiligen Innenelektroden kontaktiert sind. Hier ist ein alternierend kontaktiertes Innenelektrodendesign mit einer weitgehend einheitlichen Schichtdicke über den gesamten aktiven Bereich vorgesehen.

An den aktiven Bereich der Piezoelemente schließt sich dann der passive Kopf-und/oder Fußbereich an, in dem die Innenelektroden nicht alternierend kontaktiert sind, sondern alle jeweils an eine gleiche Außenelektrode angeschlossen sind und damit auf dem gleichen Potenzial liegen, somit also einen passiven Bereich bilden. In den Übergangsbereichen zwischen dem aktiven und dem passiven Bereich besteht jedoch die Gefahr von Rissen in der Keramik der Piezolagen aufgrund inhomogener elektrischer Feldverteilungen oder es besteht die Gefahr von Delaminationen zwischen der Keramik und den Innenelektroden aufgrund verminderter Haftfestigkeit. Beide Phänomene habe eine Verkürzung der Lebensdauer des Piezoaktors zur Folge.

### Offenbarung der Erfindung

Die Erfindung geht von einem Piezoaktor mit einem Mehrschichtaufbau von Piezoelementen aus, die jeweils aus zwischen Innenelektroden eingefassten Piezolagen bestehen. Hierbei ist über eine in einem aktiven Bereich wechselseitige seitliche Kontaktierung der Innenelektroden mittels Außenelektroden zur Betätigung des Piezoaktors eine elektrische Spannung anlegbar. Weiterhin ist mindestens ein passiver Bereich an den kopf- und/oder fußseitigen Enden des Mehrschichtaufbaus der Piezoelemente vorhanden, der keine wechselseitige Kontaktierung aufweist, wobei eine erhöhte Schichtdicke der Piezolagen im aktiven Bereich zu den kopf- und/oder fußseitigen Enden des Mehrschichtaufbaus vorhanden ist. Erfindungsgemäß ist in vorteilhafter Weise eine Erhöhung mindestens der Schichtdicke der letzten Piezolage im aktiven Bereich in Form einer mindestens gleichen Schichtdicke der mindestens ersten angrenzenden Piezolage im jeweiligen passiven Bereich zu den kopf- und/oder fußseitigen Enden des Mehrschichtaufbaus hin fortgesetzt.

Vorzugsweise kann hier auch eine graduelle Erhöhung der Schichtdicken der Piezolagen im aktiven Bereich zu den kopf- und/oder fußseitigen Enden des Mehrschichtaufbaus vorgenommen werden. Weiterhin ist es vorteilhaft, wenn die Innenelektroden des passiven Bereichs mit der gleichen Außenelektrode kontaktiert sind, wie die erste angrenzende Innenelektrode des aktiven Bereichs.

Mit der Erfindung kann in vorteilhafter Weise die Robustheit des Piezoaktors während seiner gewünschten Lebensdauer verbessert werden, da bei der aus dem Stand der Technik bekannten Auslegung des graduellen Übergangs, beispielsweise zum Aktorfuß, designbedingt zwar eine einzelne Piezolage doppelter Keramikschichtdicke zwischen den aktiven Piezolagen und dem passiven Fußbereich entsteht, jedoch die angrenzende Piezolage nur eine einfache Schichtdicke und damit ein volles elektrisches Feld und damit eine volle Dehnung aufweist und somit bei der bekannten Anordnung doch noch Risse entstehen können.

Erfindungsgemäß kann dagegen in vorteilhafter Weiterbildung der bekannten Anordnung ein besserer, insbesondere auch durchgängig gradueller Übergang der Feldstärke und der Piezoaktordehnung am Aktorfuß oder auch am Aktorkopf geschaffen werden. Ein weiterer Vorteil der Erfindung liegt darin, dass durch die vorgeschlagene neue Anordnung in den passiven Bereichen außerdem noch eine zusätzliche vorteilhafte Anpassung des Sinterverhaltens und insbesondere eine Einsparung von teurem Innenelektrodenmaterial, das oft zu 30% aus relativ teuerem Palladium besteht, erreicht werden kann.

Eine vorteilhafte Verwendung des vorgeschlagenen erfindungsgemäßen Piezoaktors ergibt sich, wenn der Piezoaktor Bestandteil eines Piezoinjektors für ein Einspritzsystem für Kraftstoff bei einem Verbrennungsmotor ist.

### Kurze Beschreibung der Zeichnungen

Ein Ausführungsbeispiel eines erfindungsgemäßen Aufbaus eines Piezoaktors wird anhand der Zeichnung erläutert. Es zeigen:
Figur 1 einen schematischen Schnitt durch wesentliche Teile eines herkömmlichen Piezoaktors mit einem Mehrschichtaufbau von Piezolagen und Innenelektroden,
Figur 2 einen Detailschnitt durch eine Anordnung von Piezolagen und
Figur 3 einen Detailschnitt durch eine erfindungsgemäße Anordnung von Piezolagen mit einem kontinuierlichen oder graduellen Übergang zwischen einem aktiven und einem passiven Bereich des Piezoaktors.

### Ausführungsformen der Erfindung

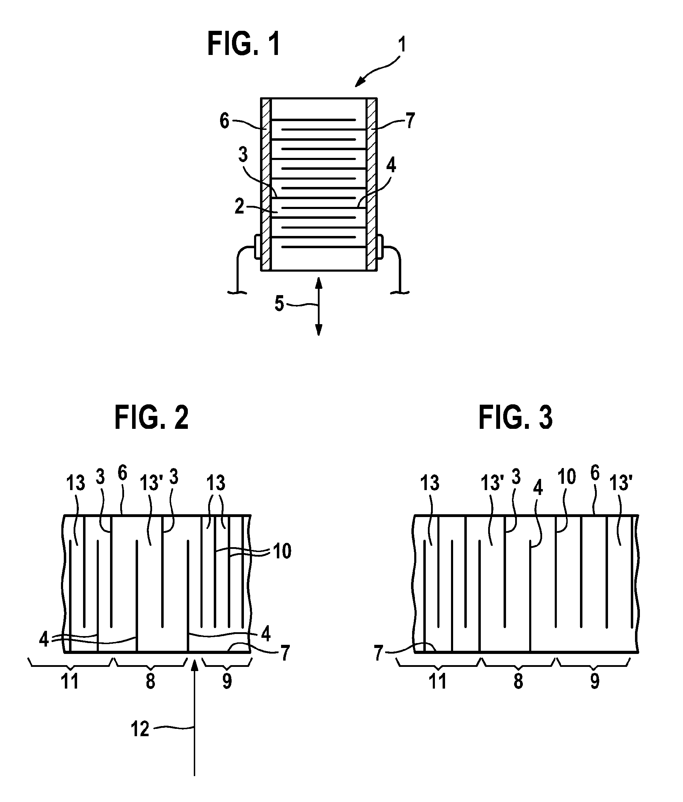

In Figur 1 ist zumindest teilweise zur Erläuterung des prinzipiellen Aufbaus ein herkömmlicher bekannter Piezoaktor 1 gezeigt, der Piezoelemente 2 mit Piezolagen oder -folien aufweist, die unter Ausnutzung des Piezoeffekts bei Anlage einer elektrischen Spannung an Innenelektroden 3 und 4 eine mechanische Reaktion des Piezoaktors 1 in axialer Richtung (Pfeil 5) bewirken.

Die Innenelektroden 3 und 4 sind dabei in Richtung des Lagenaufbaus der Piezoelemente 2 abwechselnd mit einer unterschiedlichen Polarität einer elektrischen Spannung beaufschlagt. Dies wird durch eine wechselseitige seitliche Kontaktierung der Innenelektroden 3 und 4 über Außenelektroden 6 und 7 erreicht, über die die elektrische Spannung zuführbar ist. Am oberen und am unteren Ende im Lagenaufbau der Piezoelemente 2 sind die hier nicht wechselseitig kontaktierten passiven Bereiche erkennbar über die der Piezoaktor 1 dann über einen hier nicht dargestellten Aktorfuß und/oder Aktorkopf fest in ein Gehäuse, beispielsweise das Gehäuse eines Einspritzventils für Kraftfahrzeuge, bzw. eines sogenannten Piezoinjektors, zur Steuerung dieses Ventils eingebettet werden kann.

Aus Figur 2 ist eine Anordnung von Piezolagen 13' mit doppelter Schichtdicke zwischen den Innenelektroden 3 und 4 in einem Teil 8 des aktiven Bereichs erkennbar, der an einen Teil 9 des passiven Bereichs angrenzt. In diesem passiven Bereich ist erkennbar, dass nur einseitig kontaktierte Innenelektroden 10 vorhanden sind, zwischen denen sich Piezolagen 13 mit nur einfacher Schichtdicke befinden, wie im zentralen Bereich 11 des Piezoaktors.

Im Teil 11 des aktiven Bereichs nach der Figur 2 kann hier beispielsweise eine elektrische Feldstärke von 2kV/mm, im Teil 8 eine elektrische Feldstärke von 1kV/mm und im Teil 9 des passiven Bereichs eine elektrische Feldstärke von 0kV/mm auftreten. Mit einem Pfeil 12 ist nun die erste kritische Piezolage 13 des passiven Teils 9 gekennzeichnet, die durch ihre Kontaktierung und durch die gegenüber der Piezolage 13' im Teil 8 halbierte Schichtdicke eine erhöhte Feldstärke und damit eine erhöhte Rissgefahr aufweist.

Figur 3 zeigt nunmehr eine besondere erfindungsgemäße Anordnung, bei der nicht nur die Schichtdicken der Piezolagen 13' im Teil 8 des aktiven Bereichs gegenüber den normalen Schichtdicken der Piezolagen 13 im aktiven Bereich verdoppelt sind sondern auch Piezolagen 13' mit doppelter Schichtdicke im Teil 9 des passiven Bereichs angeordnet sind. Hier ist somit die mit dem Pfeil 12 bei der bekannten Anordnung nach der Figur 2 gekennzeichnete kritische Piezolage 13 vermieden.

## Patentansprüche

1. Piezoaktor mit einem Mehrschichtaufbau von Piezoelementen (2), die jeweils aus zwischen Innenelektroden (3,4) eingefassten Piezolagen bestehen, an die in einem aktiven Bereich über eine wechselseitige seitliche Kontaktierung der Innenelektroden (3,4) mittels Außenelektroden (6,7) eine elektrische Spannung anlegbar ist und mit mindestens einem passiven Bereich an den kopf- und/oder fußseitigen Enden des Mehrschichtaufbaus der Piezoelemente (2) ohne eine wechselseitige Kontaktierung, wobei eine erhöhte Schichtdicke der Piezolagen (13') im aktiven Bereich zu den kopf- und/oder fußseitigen Enden des Mehrschichtaufbaus vorhanden ist und sich eine Erhöhung mindestens der Schichtdicke der letzten Piezolage (13') im aktiven Bereich in Form einer mindestens gleichen Schichtdicke der mindestens ersten angrenzenden Piezolage (13') im jeweiligen passiven Bereich zu den kopf- und/oder fußseitigen Enden des Mehrschichtaufbaus hin fortsetzt.

2. Piezoaktor nach Anspruch 1, **dadurch gekennzeichnet, dass** eine graduelle Erhöhung der Schichtdicken der Piezolagen (13') im aktiven Bereich zu den kopf- und/oder fußseitigen Enden des Mehrschichtaufbaus hin vorhanden ist.

3. Piezoaktor nach Anspruch 1 oder 2, **dadurch gekennzeichnet, dass** die Innenelektroden (3,4) des passiven Bereichs mit der jeweils gleichen Außenelektrode (6,7) kontaktiert sind, wie die erste angrenzende Innenelektrode (3,4) des aktiven Bereichs.

4. Verwendung eines Piezoaktors nach einem der vorhergehenden Ansprüche, **dadurch gekennzeichnet, dass** der Piezoaktor Bestandteil eines Piezoinjektors für ein Einspritzsystem für Kraftstoff bei einem Verbrennungsmotor ist.
